# EUROPÄISCHE PATENTANMELDUNG

(11) **EP 0 789 446 A1**
(43) Veröffentlichungstag der Anmeldung: **13.08.1997**
(21) Anmeldenummer: 97810025.3
(22) Anmeldetag: 21.01.1997
(51) Int. Cl.: H02M 7/00, H01R 13/53

(54) **Leistungshalbleitermodul**

(30) Priorität: 06.02.1996 US 597133
(71) Anmelder: ASEA BROWN BOVERI AG, 5400 Baden (CH)
(72) Erfinder: Bayerer, Reinhold, Dr., 64385 Rechelsheim (DE); Hilpert, Gerald, 79787 Lauchringen (DE); Schifferli, Rolf, 5318 Mandach (CH)
(74) Vertreter: Weibel, Beat

(57) **Zusammenfassung**

Es wird ein Leistungshalbleitermodul angegeben. Dieses umfasst ein Gehäuse, in das eine beliebige Leistungshalbleiterschaltung eingebaut ist. Die Leistungshalbleiterschaltung weist mindestens zwei Anschlüsse auf, die aus dem Gehäuse herausgeführt sind. Nach der Erfindung weisen die Anschlüsse die Form eines langgestreckten Steckkontaktes auf. Zwischen den benachbarten Steckkontakten kann ausserdem eine Isolierplatte vorgesehen werden. Durch diese Form der Anschlüsse erreicht man einen sicheren, aber einfach lösbaren, niederinduktiven elektrischen Kontakt.

## Beschreibung

### Technisches Gebiet

Die Erfindung bezieht sich auf das Gebiet der Leistungselektronik. Sie geht aus von einem Leistungshalbleitermodul nach dem Oberbegriff des ersten Anspruchs.

### Stand der Technik

Ein derartiges Leistungshalbleitermodul wird z.B. in der Europäischen Patentanmeldung EP 0 597 144 A1 beschrieben. Leistungshalbleitermodule nach dem Stand der Technik weisen ein Gehäuse auf, in welchem eine Leistungshalbleiterschaltung angeordnet ist. Die Funktion und der Aufbau der Leistungshalbleiterschaltung ist beliebig und für die Erfindung nicht entscheidend. Die Anschlüsse der Leistungshalbleiterschaltung werden aus dem Gehäuse herausgeführt. Dort werden sie z.B. von Stromschienen oder von Kabeln kontaktiert. Zu diesem Zweck sind die Anschlüsse wie z.B. in der eingangs genannten Schrift mit Löchern zur Durchführung eines Schraubenkontaktes ausgerüstet. Nachteilig an so gestalteten Modulen ist, dass der Schraubenkontakt nicht ohne Werkzeug gelöst werden kann. Zwar wäre auch eine Verbindung mit Steckern und Buchsen denkbar, diese weist aber für die geforderten hohen Ströme eine zu geringe Kontaktfläche auf. Die Verwendung von Anschlusskabeln mit Steck- oder Schraubenkontakten ist auch im Hinblick auf durch Kabelschleifen hervorgerufene Induktivitäten nicht von Vorteil.

### Darstellung der Erfindung

Aufgabe der vorliegenden Erfindung ist es, einen Leistungshalbleitermodul anzugeben, bei welchem der elektrische Kontakt zu den Stromschienen auf äusserst einfache Weise hergestellt werden kann und welches trotzdem eine hinreichende Kontaktfläche zwischen den Modulanschlüssen und den Stromschienen aufweist. Ausserdem soll die Kontaktierung möglichst niederinduktiv aufgebaut sein.

Diese Aufgabe wird bei einem Leistungshalbleitermodul der eingangs genannten Art durch die Merkmale des ersten Anspruchs gelöst.

Kern der Erfindung ist es also, dass die Anschlüsse des Moduls die Form eines langgestreckten Steckkontaktes aufweisen. Vorzugsweise ist zwischen zwei benachbart angeordneten Steckkontakten eine Isolierplatte vorgesehen. Die Steckkontakte können an einer Längsseite des Modulgehäuses angebracht werden und erstrecken sich z.B. mindestens über die Hälfte der Längsseite des Modulgehäuses.

Besonders bevorzugt wird eine Ausführungsform, bei welcher die Steckkontakte eine Vielzahl von parallelen Kontaktstelle umfassen. Dadurch erreicht man einen sicheren elektrischen Kontakt. Die Steckkontakte sind für ein Zusammenwirken mit Anschlusschienen oder Anschlussblechen ausgebildet und weisen im wesentlichen ein "U"-förmiges Profil auf, wobei an beiden Schenkelenden gegenüberliegende, die Kontaktstellen bildende Verdickungen angebracht sind.

Es wird ausserdem eine Leistungshalbleiterschaltungsanordnung angegeben, die Leistungshalbleitermodule und Anschlussbleche aufweist. Die Anschlussbleche sind für ein Zusammenwirken mit den Steckkontakten der Module ausgebildet.

Weitere Ausführungsform ergeben sich aus den entsprechenden abhängigen Ansprüchen.

Der Vorteil der Erfindung liegt insbesondere darin, dass durch einfaches Aufstecken der Module auf die Anschlussschienen ein sicherer elektrischer Kontakt erreicht wird und dass die Module zudem sehr einfach wieder von den Anschlussschienen getrennt werden können. Ausserdem ist die Kontaktanordnung aufgrund der vergleichsweise grossen Kontaktfläche niederinduktiv.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine perspektivische Ansicht eines erfindungsgemässen Moduls;
- **Fig. 2**: Einen Teil eines Modulgehäuses im Schnitt;
- **Fig. 3**: Eine Detailansicht der Steckkontakte im Schnitt, sowie eine Anordnung von Anschlussblechen, auf welche ein erfindungsgemässes Modul aufgesteckt werden kann;
- **Fig.4, 5**: Eine Aufsicht auf zwei Anschlussbleche, die für den Aufbau einer Schaltungsanordnung mit erfindungsgemässen Modulen geeignet sind.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

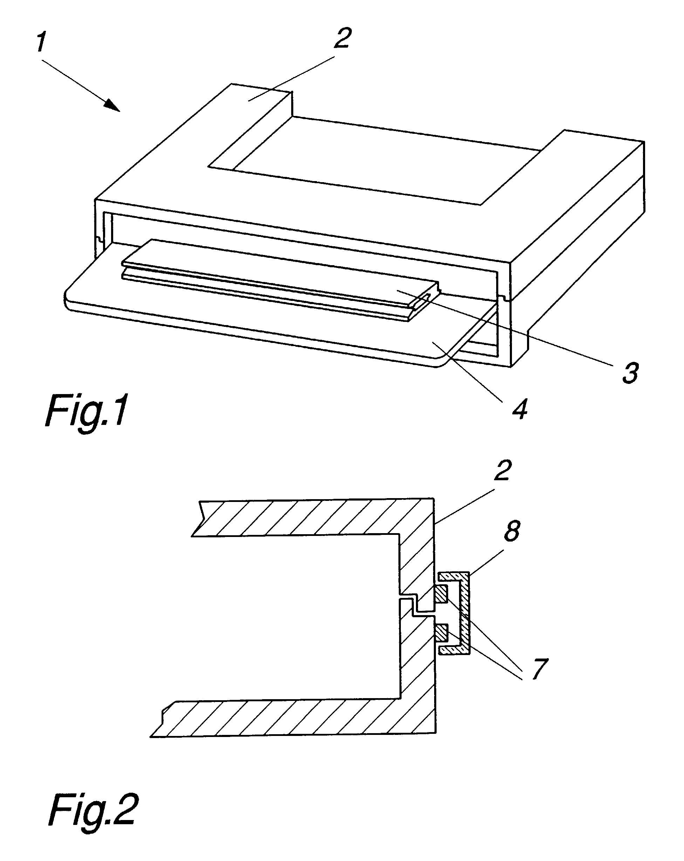

Figur 1 zeigt eine perspektivische Ansicht eines erfindungsgemässen Leistungshalbleitermoduls 1. Dieses umfasst ein Gehäuse 2, in das eine beliebige Leistungshalbleiterschaltung (nicht ersichtlich) eingebaut ist. Die Leistungshalbleiterschaltung weist mindestens zwei Anschlüsse auf, die aus dem Gehäuse 2 herausgeführt sind. Nach der Erfindung weisen die Anschlüsse die Form eines langgestreckten Steckkontaktes 3 auf. Zwischen den benachbarten Steckkontakten kann ausserdem eine Isolierplatte 4 vorgesehen werden.

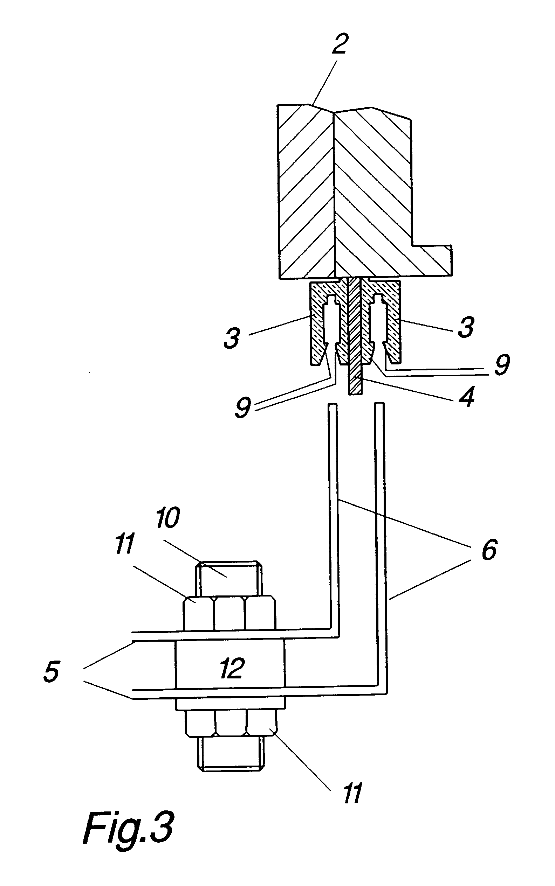

Figur 3 zeigt die Steckkontakte 3 detaillierter. Sie weisen ein im wesentliches "U"-förmiges Profil auf. An den Enden der Schenkel sind verdickte Kontaktstellen 9 angeordnet. Wird nun ein elektrisch leitendes Blech z.B. in Form einer Lasche 6 eines Anschlussbleches 5 in den Steckkontakt 3 eingeführt, so wird der Steckkontakt aufgrund des leicht kleineren Abstandes der Kontaktstellen 9 verglichen mit der Blechdicke ein wenig aufgedrückt. Die Kontaktstellen üben dadurch aufgrund der Elastizität des Steckkontaktmaterials einen Druck auf das eingeführte Blech auf, so dass ein guter elektrischer Kontakt hergestellt wird.

Besonders bevorzugt wird ein Steckkontakt, dessen Kontaktstellen aus einer Vielzahl von parallelen Vorsprüngen besteht. Dadurch wird ein guter elektrischer Kontakt zu den Laschen 6 der Anschlussbleche 5 gewährleistet.

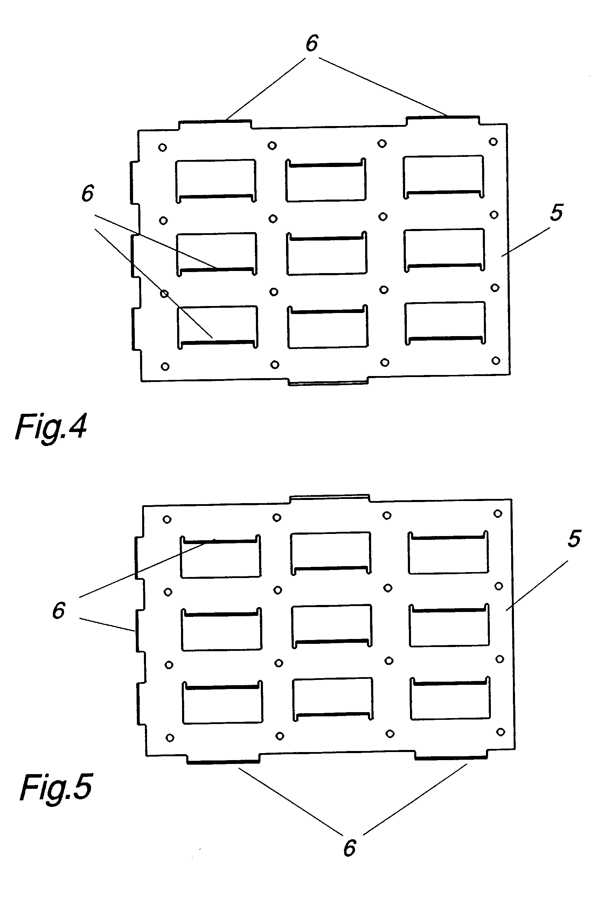

Die Anschlussbleche 5 bilden einen Teil einer Leistungshalbleiterschaltungsanordnung. Die Anschlussbleche können, wie in Figur 3 dargestellt ist, übereinander gestapelt und mittels Schrauben 10, Muttern 11 und eingeführten Isolierhülsen 12 untereinander oder auf einem nicht dargestellten Träger befestigt sein. Damit die Module mit ihren Steckkontakten 3 auf die Anschlussbleche 5 aufgesteckt werden können, sind Laschen 6 vorgesehen. Die Anschlussbleche 5 weisen vorzugsweise, siehe Figuren 4 und 5, einen gitterförmigen Aufbau auf. Die Laschen 6, die im wesentlichen rechtwinklig zu den Anschlussblechen 5 nach oben gebogen oder angeschweisst sind, werden vorzugsweise in den Aussparungen und an den Rändern der Gitter in regelmässigen Abständen vorgesehen. Werden zwei derartige Anschlussbleche 5 aufeinandergestapelt, wobei das eine um 180° gedreht ist, so entsteht ein Anordnung, welche es erlaubt, über den Stegen der Gitter immer zwei Module aufzustecken. Die vergleichsweise grosse Fläche der Anschlussbleche ermöglicht einen niederinduktiven Aufbau.

Figur 2 zeigt ein Detail des Modulgehäuseaufbaus. Das Gehäuse 2 umfasst eine obere und eine untere Hälfte, die schienenartig ineinander gefügt sind. Zur Fixierung der beiden Hälften ist in der Nähe der Fuge pro Hälfte je ein Führungssteg 7 vorgesehen. Die Führungsstege 7 werden durch eine U-Schiene 8 zusammengehalten. Auf diese Weise erreicht man ein Gehäuse, das auf einfache Weise zusammengefügt werden kann, das aber dennoch einen mechanisch robusten Aufbau aufweist. Insgesamt steht also mit der Erfindung ein Leistungshalbleitermodul zur Verfügung, mit dem ein platzsparender, mechanisch aber dennoch robuster, aufgrund des Wegfalls von Kabelschleifen niederinduktiver und elektrisch sicherer Kontakt erreicht werden kann.

### Bezugszeichenliste

- 1: Leistungshalbleitermodul
- 2: Modulgehäuse
- 3: Steckkontakt
- 4: Isolierplatte
- 5: Anschlussblech
- 6: Lasche
- 7: Führungssteg
- 8: U-Schiene
- 9: Kontaktstelle
- 10: Schraube
- 11: Mutter
- 12: Isolierhülse

## Patentansprüche

1. Leistungshalbleitermodul (1), umfassend eine in einem Modulgehäuse (2) untergebrachte Leistungshalbleiterschaltung mit mindestens zwei aus dem Modulgehäuse (2) herausgeführten Anschlüssen, dadurch gekennzeichnet, dass die Anschlüsse eine Form eines langgestreckten Steckkontaktes (3) aufweisen.

2. Leistungshalbleitermodul nach Anspruch 1, dadurch gekennzeichnet, dass die Anschlüsse nebeneinander angeordnet sind und dass zwischen den Steckkontakten (3) eine Isolierplatte (4) vorgesehen ist.

3. Leistungshalbleitermodul nach Anspruch 2, dadurch gekennzeichnet, dass die Steckkontakte (3) eine Vielzahl von parallelen Kontaktstellen (9) aufweisen.

4. Leistungshalbleiterschaltungsanordnung, umfassend eine Mehrzahl von Leistungshalbleitermodulen (1) und mehrere Anschlussbleche (5), dadurch gekennzeichnet, dass die Leistungshalbleitermodule nach einem der vorstehende Ansprüche aufgebaut sind und die Anschlussbleche für ein Zusammenwirken mit den Steckkontakten (3) der Leistungshalbleitermodule ausgebildet sind.

5. Leistungshalbleiterschaltungsanordnung nach Anspruch 4, dadurch gekennzeichnet, dass die Anschlussbleche (5) übereinander angeordnet sind und eine gitterförmige, mit Aussparungen versehene Form aufweisen und dass die Stege der gitterförmigen Anschlussbleche im Bereich der Aussparungen und am Rand der Anschlussbleche im wesentlichen rechtwinklig abstehende, mit den Steckkontakten (3) zusammenwirkende Laschen (6) aufweisen.
